# EUROPEAN PATENT APPLICATION

(11) **EP 4 443 257 A1**
(43) Date of publication of application: **09.10.2024**
(21) Application number: 22919421.2
(22) Date of filing: 13.01.2022
(51) Int. Cl.: G05B 23/00, G06F 30/20, G06F 30/00

(54) **TEST METHOD AND APPARATUS**

(71) Applicant: Huawei Technologies Co., Ltd., Shenzhen, Guangdong 518129 (CN)
(72) Inventor: LUO, Daxin, Shenzhen, Guangdong 518129 (CN); MA, Sha, Shenzhen, Guangdong 518129 (CN)
(74) Representative: MERH-IP Matias Erny Reichl Hoffmann Patentanwälte PartG mbB
(86) International application number: PCT/CN2022/071826
(87) International publication number: WO 2023/133758

(57) **Abstract**

This application relates to a test method and apparatus, and this application relates to the field of intelligent transportation and intelligent driving technologies. The method includes: obtaining a first scenario; and determining a first test method based on the first scenario, where the first test method corresponds to the first scenario, and the first test method is used to test performance of an intelligent driving system in the first scenario. The intelligent driving system can be applied to a vehicle. The test method and apparatus provided in embodiments of this application can improve accuracy of a performance test of the intelligent driving system in a scenario, to improve driving safety of the vehicle.

## Description

### TECHNICAL FIELD

This application relates to the field of intelligent transportation and intelligent driving technologies, and in particular, to a test method and apparatus.

### BACKGROUND

In recent years, autonomous driving technologies are rapidly developing. As a means of transportation, a vehicle brings a plurality of safety risks while bringing convenience to people. Traffic accidents often occur in people's life and threaten human life, health, and property safety. Therefore, safety becomes a most critical factor of an autonomous driving system (Autonomous Driving System, ADS) or an intelligent driving system, and an autonomous vehicle needs to be controlled and driven under a prerequisite of safety.

Safety of the intended functionality (Safety of The Intended Functionality, SOTIF) is defined as follows: There is no unreasonable risk, and a risk is caused by performance limitation of expected behavior or abuse that is proper foreseen by a user. The performance limitation means that functions of the autonomous driving system are not perfect, and the abuse means that the autonomous driving system is not used by a person based on requirements of a manufacturer and the system.

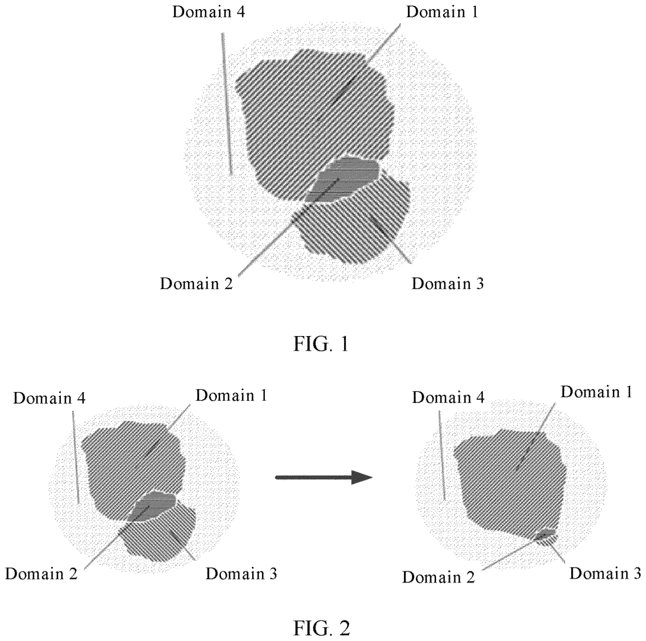

In the SOTIF, there are four types of driving scenarios: known safe scenarios (Known Safe Scenarios), known unsafe scenarios (Known Unsafe Scenarios), unknown unsafe scenarios (Unknown Unsafe Scenarios), and unknown safe scenarios (Unknown Safe Scenarios). FIG. 1 is a schematic diagram of an example of a driving scenario. As shown in FIG. 1, a domain 1 represents a known safe scenario, a domain 2 represents a known unsafe scenario, a domain 3 represents an unknown unsafe scenario, and a domain 4 represents an unknown safe scenario. It is very important to test whether performance of the intelligent driving system is safe in a scenario. Therefore, how to accurately test performance of the intelligent driving system in a scenario is an urgent problem to be resolved currently.

### SUMMARY

In view of this, a test method is provided, to improve accuracy of a performance test of an intelligent driving system in a scenario.

According to a first aspect, an embodiment of this application provides a test method. The method includes: obtaining a first scenario; and determining a first test method based on the first scenario, where the first test method corresponds to the first scenario, and the first test method is used to test performance of an intelligent driving system in the first scenario.

In this embodiment of this application, a test method for performing a performance test on the intelligent driving system is determined based on a scenario in which a test needs to be performed, so that adaptation between the test method and the scenario in which the test needs to be performed is improved, and accuracy of the performance test of the intelligent driving system in the scenario is improved.

According to the first aspect, in a first possible implementation of the method, the method further includes: testing the performance of the intelligent driving system in the first scenario based on the first test method, to obtain a test result.

In this embodiment of this application, the performance is tested by the test method that is applicable to the scenario, the accuracy of the performance test of the intelligent driving system in the scenario can be improved.

According to the first possible implementation of the first aspect, in a second possible implementation of the method, the first test method indicates a first test manner, first test content, and a first test indicator. The testing the performance of the intelligent driving system in the first scenario based on the first test method, to obtain a test result includes: simulating the first scenario based on the first test manner; in a simulated first scenario, running the intelligent driving system based on the first test content, to obtain running data of the intelligent driving system in the first scenario; and determining, based on whether the running data meets the first test indicator, whether the test result is that a test is passed or the test is not passed.

According to the first possible implementation or the second possible implementation of the first aspect, in a third possible implementation of the method, the method further includes:
when the test result is that the test is passed, adding the first scenario to a scenario library supported by the intelligent driving system, and recording a sensing capability and a driving strategy of the intelligent driving system running in the first scenario.

In this way, when encountering the first scenario again, the intelligent driving system may run based on the sensing capability and the driving strategy that correspond to the first scenario, to implement safe driving.

According to any one of the first possible implementation to the third possible implementation of the first aspect, in a fourth possible implementation of the method, the method further includes:
when the test result is that the test is not passed, analyzing a reason why the test of the intelligent driving system in the first scenario is not passed; and
updating the intelligent driving system based on the reason, to enable the test result of the intelligent driving system in the first scenario to be changed to that the test is passed.

According to the fourth possible implementation of the first aspect, in a fifth possible implementation of the method, the updating the intelligent driving system based on the reason includes:
when the reason is a sensor sensing error, improving the sensing capability of the intelligent driving system in the first scenario; and/or
when the reason is a driving strategy parameter error, adjusting the driving strategy of the intelligent driving system in the first scenario.

In this embodiment of this application, the reason why the test of the intelligent driving system in the first scenario is not passed can be analyzed, and the intelligent driving system is updated, so that the test result of the intelligent driving system in the first scenario is changed to that the test is passed. In other words, the first scenario is changed from an unsafe scenario to a safe scenario.

According to any one of the second possible implementation to the fifth possible implementation of the first aspect, in a sixth possible implementation of the method, the method further includes:
when the test result is that the test is passed, sending, to a cloud and/or another vehicle, the first scenario, and the sensing capability and the driving strategy of the intelligent driving system running in the first scenario, to enable the cloud and/or the another vehicle to update the scenario library supported by the intelligent driving system, and record the sensing capability and the driving strategy of the intelligent driving system running in the first scenario.

According to any one of the second possible implementation to the sixth possible implementation of the first aspect, in a seventh possible implementation of the method, the method further includes:
when the test result is that the test is passed, sending the first scenario and the first test method to the cloud and/or the another vehicle, to enable the cloud and/or the another vehicle to test the performance of the intelligent driving system in the first scenario based on the first test method.

According to any one of the second possible implementation to the seventh possible implementation of the first aspect, in an eighth possible implementation of the method,
the first test manner includes at least one or more of simulation evaluation, a closed field test, and an actual road test;
the first test content includes at least one or more of compliance, a danger degree, and driving stability; and
the first test indicator includes at least one or more of a safety distance and/or a traffic rule.

According to the first aspect, or any one of the possible implementations of the first aspect, in a ninth possible implementation of the method, the first scenario indicates one or more of time information, weather information, terrain information, road information, and motion status information of a traffic participant; and
the obtaining a first scenario includes:
when an error occurs during running of the intelligent driving system of an ego vehicle or a danger is prompted, obtaining one or more of current time information, weather information, terrain information, road information, and motion status information of a traffic participant, to obtain the first scenario.

According to the ninth possible implementation of the first aspect, in a tenth possible implementation of the method, the determining a first test method based on the first scenario includes:
determining, based on construction difficulty of an actual scenario of the first scenario, a test manner that is applicable to the first scenario;
determining, based on a safety need of the first scenario, test content and a test indicator that are applicable to the first scenario; and
determining, based on the test manner, the test content, and the test indicator that are applicable to the first scenario, the first test method that corresponds to the first scenario.

According to a second aspect, an embodiment of this application provides a test apparatus. The test apparatus includes: an obtaining module, configured to obtain a first scenario; and a determining module, configured to determine a first test method based on the first scenario, where the first test method corresponds to the first scenario, and the first test method is used to test performance of an intelligent driving system in the first scenario.

According to the second aspect, in a first possible implementation of the apparatus, the apparatus further includes:
a test module, configured to test the performance of the intelligent driving system in the first scenario based on the first test method, to obtain a test result.

According to the first possible implementation of the second aspect, in a second possible implementation of the apparatus, the first test method indicates a first test manner, first test content, and a first test indicator, and the test module is further configured to:
simulate the first scenario based on the first test manner;
in a simulated first scenario, run the intelligent driving system based on the first test content, to obtain running data of the intelligent driving system in the first scenario; and
determine, based on whether the running data meets the first test indicator, whether the test result is that a test is passed or the test is not passed.

According to the first possible implementation or the second possible implementation of the second aspect, in a third possible implementation of the apparatus, the apparatus further includes:
a recording module, configured to: when the test result is that the test is passed, add the first scenario to a scenario library supported by the intelligent driving system, and record a sensing capability and a driving strategy of the intelligent driving system running in the first scenario.

According to any one of the first possible implementation to the third possible implementation of the second aspect, in a fourth possible implementation of the apparatus, the apparatus further includes:
an analysis module, configured to: when the test result is that the test is not passed, analyze a reason why the test of the intelligent driving system in the first scenario is not passed; and
an updating module, configured to update the intelligent driving system based on the reason, to enable the test result of the intelligent driving system in the first scenario to be changed to that the test is passed.

According to the fourth possible implementation of the second aspect, in a fifth possible implementation of the apparatus, based on the reason, the updating module is further configured to:
when the reason is a sensor sensing error, improve the sensing capability of the intelligent driving system in the first scenario; and/or
when the reason is a driving strategy parameter error, adjust the driving strategy of the intelligent driving system in the first scenario.

According to any one of the second possible implementation to the fifth possible implementation of the second aspect, in a sixth possible implementation of the apparatus, the apparatus further includes:
a first sending module, configured to: when the test result is that the test is passed, send, to a cloud and/or another vehicle, the first scenario, and the sensing capability and the driving strategy of the intelligent driving system running in the first scenario, to enable the cloud and/or the another vehicle to update the scenario library supported by the intelligent driving system, and record the sensing capability and the driving strategy of the intelligent driving system running in the first scenario.

According to any one of the second possible implementation to the sixth possible implementation of the second aspect, in a seventh possible implementation of the apparatus, the apparatus further includes:
a second sending module, configured to: when the test result is that the test is passed, send the first scenario and the first test method to the cloud and/or the another vehicle, to enable the cloud and/or the another vehicle to test the performance of the intelligent driving system in the first scenario based on the first test method.

According to any one of the second possible implementation to the seventh possible implementation of the second aspect, in an eighth possible implementation of the apparatus, the first test manner includes at least one or more of simulation evaluation, a closed field test, and an actual road test; the first test content includes at least one or more of compliance, a danger degree, and driving stability; and the first test indicator includes at least one or more of a safety distance and/or a traffic rule.

According to the second aspect or any one of the possible implementations of the second aspect, in a ninth possible implementation of the apparatus, the first scenario indicates one or more of time information, weather information, terrain information, road information, and motion status information of a traffic participant; and
the obtaining module is further configured to:
when an error occurs during running of the intelligent driving system of an ego vehicle or a danger is prompted, obtain one or more of current time information, weather information, terrain information, road information, and motion status information of a traffic participant, to obtain the first scenario.

According to the ninth possible implementation of the second aspect, in a tenth possible implementation of the apparatus, the determining module is further configured to:
determine, based on construction difficulty of an actual scenario of the first scenario, a test manner that is applicable to the first scenario;
determine, based on a safety need of the first scenario, test content and a test indicator that are applicable to the first scenario; and
determine, based on the test manner, the test content, and the test indicator that are applicable to the first scenario, the first test method that corresponds to the first scenario.

According to a third aspect, an embodiment of this application provides a test apparatus. The test apparatus may perform one or more test methods according to the first aspect or the plurality of possible implementations of the first aspect.

According to a fourth aspect, an embodiment of this application provides a non-volatile computer-readable storage medium, storing computer program instructions. When the computer program instructions are executed by a processor, one or more test methods are performed according to the first aspect or the plurality of possible implementations of the first aspect.

According to a fifth aspect, an embodiment of this application provides a computer program product, including computer-readable code or a non-volatile computer-readable storage medium carrying computer-readable code. When the computer-readable code runs in an electronic device, a processor in the electronic device performs one or more test methods according to the first aspect or the possible implementations of the first aspect.

These aspects and other aspects of this application are more concise and more comprehensive in descriptions of the following (a plurality of) embodiments.

### BRIEF DESCRIPTION OF DRAWINGS

The accompanying drawings included in this specification and constituting a part of this specification and this specification jointly show example embodiments, features, and aspects of this application, and are intended to explain the principles of this application.
FIG. 1 is a schematic diagram of an example of a driving scenario;
FIG. 2 is a schematic diagram of evolution of a domain;
FIG. 3 is a schematic diagram of a structure of a test system according to an embodiment of this application;
FIG. 4 is a flowchart of a test method according to an embodiment of this application;
FIG. 5 is a flowchart of a test method according to an embodiment of this application;
FIG. 6 is an interaction flowchart of a test method according to an embodiment of this application;
FIG. 7 is a schematic diagram of a structure of a test apparatus according to an embodiment of this application; and
FIG. 8 is a schematic diagram of a structure of an electronic device according to an embodiment of this application.

### DESCRIPTION OF EMBODIMENTS

The following describes various example embodiments, features, and aspects of this application in detail with reference to the accompanying drawings. Identical reference signs in the accompanying drawings indicate elements that have same or similar functions. Although various aspects of embodiments are shown in the accompanying drawings, unless otherwise specified, the accompanying drawings do not need to be drawn to scale.

The specific term "example" herein means "used as an example, embodiment or illustration". Any embodiment described as an "example" is not necessarily explained as being superior or better than other embodiments.

In addition, to better describe this application, numerous specific details are given in the following specific implementations. A person skilled in the art should understand that this application may also be implemented without some specific details. In some embodiments, methods, means, elements, and circuits that are well-known to a person skilled in the art are not described in detail, so that the subject matter of this application is highlighted.

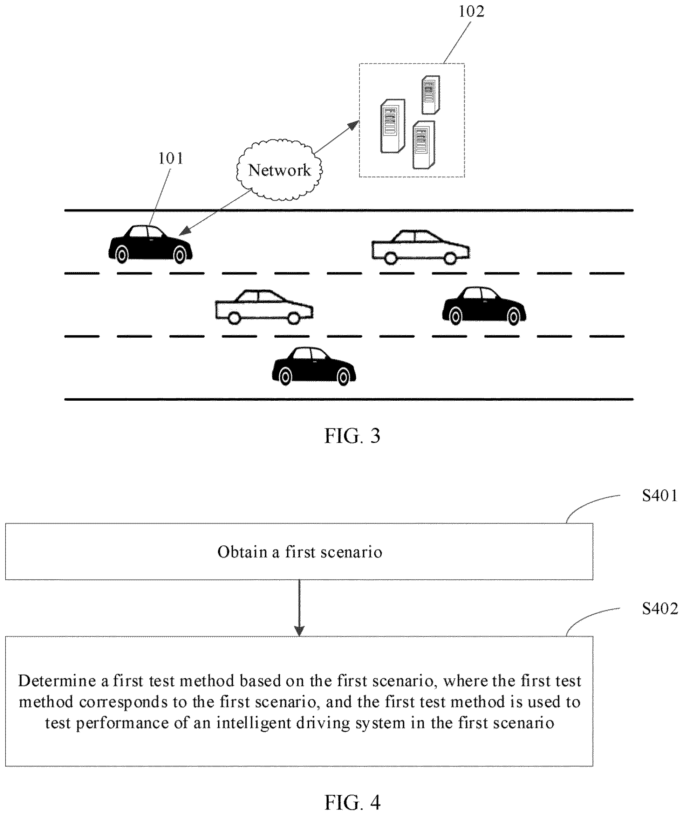

FIG. 3 is a schematic diagram of a structure of a test system according to an embodiment of this application. The system includes an intelligent driving apparatus 101 and a test apparatus 102. The intelligent driving apparatus 101 and the test apparatus 102 may communicate with each other through a network. The intelligent driving apparatus 101 may run in a scenario, and send running data to the test apparatus 102. The test apparatus 102 may test performance of an intelligent driving system configured in the intelligent driving apparatus 101.

In a possible implementation, the intelligent driving apparatus 101 may be an electronic device that has an intelligent driving capability and a data sending and receiving capability. For example, the intelligent driving apparatus 101 may be an actual vehicle that is equipped with one or more sensors such as a lidar, a camera, a global navigation satellite system (Global Navigation Satellite System, GNSS), and an inertial measurement unit (Inertial Measurement Unit, IMU). In another possible implementation, the intelligent driving apparatus 101 may be a simulated vehicle that is controlled by an intelligent driving system externally connected to a simulation system.

In a possible implementation, the test apparatus 102 may be an electronic device that has a data processing capability and a data sending and receiving capability, may be a physical device like a host, a framework server, or a blade server, or may be a virtual device like a virtual machine or a container. The test apparatus 102 may be deployed in a cloud, or may be deployed in an actual vehicle. This is not limited in this embodiment of this application.

A scenario in which the intelligent driving apparatus 101 runs may be a safe scenario, or may be an unsafe scenario. The test apparatus 102 may test the performance of the intelligent driving system configured in the intelligent driving apparatus 101.

In this embodiment of this application, intelligent driving indicates a technology in which a machine helps a person drive and completely replaces the person to drive in a special case. The intelligent driving includes three links: network navigation, autonomous driving, and manual intervention. The network navigation of the intelligent driving resolves a problem, for example, where we are, where we go, and which lane on which road we go. The autonomous driving refers to driving behavior completed under control of an intelligent system, for example, lane keeping, overtaking, lane merging, stopping at a red light, running at a green light, and interacting of lights and whistles. The manual intervention refers to a response of a driver to an actual road condition under a series of prompts of the intelligent system. The intelligent driving system is a system used to implement an intelligent driving technology. In this embodiment of this application, the intelligent driving system includes but is not limited to an assisted driving system and an autonomous driving system. A vehicle (that is, an intelligent vehicle) deployed with the intelligent driving system may use a technology such as a computer, modern sensing, information fusion, communication, artificial intelligence, and automatic control on implement environment sensing, planning, and decision-making, and enable multi-level assisted driving functions, to improve safety.

Embodiments of this application provide a test method. The method may be applied to an electronic device like the test apparatus 102 shown in FIG. 3. According to the test method provided in embodiments of this application, a test method for performing a performance test on the intelligent driving system can be determined based on a scenario in which a test needs to be performed, so that adaptation between the test method and the scenario in which the test needs to be performed is improved, and accuracy of the performance test of the intelligent driving system in the scenario is improved.

FIG. 4 is a flowchart of a test method according to an embodiment of this application. As shown in FIG. 4, the test method may include the following steps.

Step S401: Obtain a first scenario.

The first scenario may indicate a scenario in which a test is currently performed. In a possible implementation, the first scenario may include a known unsafe scenario (that is, a scenario in which an intelligent driving system makes a mistake) and a scenario that is not in an operational design domain (Operational Design Domain, ODD).

In a possible implementation, the first scenario may indicate one or more of time information, weather information, terrain information, road information, and motion status information of a traffic participant. The time information may indicate time at which the first scenario appears. For example, the time information may be morning, afternoon, or night. Alternatively, the time information may be a season or a month. The weather information may indicate weather when the first scenario occurs. For example, the weather information may be a sunny day, a cloudy day, a foggy day, a rainy day, or a snowy day. Alternatively, the weather information may be further divided at a finer granularity, for example, heavy fog or heavy rain. The terrain information may indicate a terrain involved in the first scenario. For example, the terrain information may be a flat ground or a pit. The road information may indicate a status of a road in the first scenario. For example, the road information may be an urban road, a rural road, a mountainous road, a single lane, a multi-lane, or a one-way street. The motion status information of the traffic participant may indicate a motion status of the traffic participant that appears in the first scenario. For example, the traffic participant includes but is not limited to a pedestrian, a non-motorized vehicle, a motor vehicle, a green belt, a traffic light, and a street building. The motion status information of the traffic participant includes but is not limited to a location, a driving direction, a speed, an acceleration, and status information (a red light, a green light, a yellow light, and flashing) of the traffic light. In an example, a first scenario A may indicate a night, a rainy day, a mountainous area, and a national highway, and a first scenario B may indicate daytime, a sunny day, a suburb, and an expressway.

In a possible implementation, for any known unsafe scenario, the first scenario may be obtained based on one or more of time information, weather information, terrain information, road information, and motion status information of a traffic participant when the unsafe scenario occurs. In this embodiment of this application, a test method may be re-adapted to the known unsafe scenario for performing re-testing, to change the known unsafe scenario to a known safe scenario.

In a possible implementation, for any scenario that is not in the ODD, the first scenario may be obtained based on current information. In an example, when an error occurs during running of the intelligent driving system of an ego vehicle or a danger is prompted, one or more of current time information, weather information, terrain information, road information, and motion status information of a traffic participant may be obtained, to obtain the first scenario. In this embodiment of this application, when a scenario that does not appear is encountered, if an error occurs during running of the intelligent driving system (for example, a speed cannot be limited in advance when a curve is entered; after a driver controls a steering wheel, there are two extremes of the system: strong confrontation or extremely easy exit; or in a horizontal control process, the vehicle deviates from a lane at a high speed due to overadjustment on control), or a danger (for example, there is a prompt of a rear-end collision danger or a prompt of a lateral drift danger) is prompted, it indicates that the current scenario may be the unsafe scenario. Therefore, one or more of the current time information, weather information, terrain information, road information, and motion status information of the traffic participant may be obtained to obtain the first scenario, and then the first scenario is tested, so that the unknown scenario is changed to the known safe scenario.

Step S402: Determine a first test method based on the first scenario, where the first test method corresponds to the first scenario, and the first test method is used to test performance of the intelligent driving system in the first scenario.

The first test method may indicate a test method that corresponds to the first scenario. The first test method highly adapts to the first scenario. When the first test method is used to test the performance of the intelligent driving system in the first scenario, accuracy of an obtained test result is high.

In a possible implementation, the first test method may indicate a first test manner, first test content, and a first test indicator. The first test manner may indicate a test manner that is applicable to a first test scenario. For example, the first test manner includes at least one or more of simulation evaluation, a closed field test, and an actual road test. The first test content may indicate test content to be tested when the performance of the intelligent driving system in the first scenario is tested. For example, the first test content includes at least one or more of compliance, a danger degree, and driving stability. The first test indicator may indicate a test indicator used to evaluate running data when the performance of the intelligent driving system in the first scenario is tested. For example, the first test indicator includes at least one or more of a safety distance and/or a traffic rule. It should be noted that the first test manner, the first test content, and the first test indicator are described as examples, and are not intended for limitation.

In a possible implementation, step S402 may include: determining, based on construction difficulty of an actual scenario of the first scenario, a test manner that is applicable to the first scenario; determining, based on a safety need of the first scenario, test content and a test indicator that are applicable to the first scenario; and determining, based on the test manner, the test content, and the test indicator that are applicable to the first scenario, the first test method that corresponds to the first scenario.

In an example, when the construction difficulty of the actual scenario of the first scenario is high, the simulation evaluation may be determined that the test manner is applicable to the first scenario. For example, when the construction difficulty of the actual scenario like a rainy day scenario, a foggy day scenario, or a mountainous scenario, the simulation evaluation may be determined as a corresponding test manner. When the construction difficulty of the actual scenario of the first scenario is low, the closed field test or the actual road test may be determined as the test manner that is applicable to the first scenario. For example, when the construction difficulty of the actual scenario like a parking lot scenario, an urban road scenario, or a sunny day scenario, the closed field test or the actual road test may be determined as the test manner that is applicable to the first scenario. In a possible implementation, there may be a plurality of first test manners that correspond to the first scenario. In other words, the performance of the intelligent driving system in the first scenario may be tested in the plurality of test manners, for example, in both the simulation manner and the closed field test.

In an example, when the first scenario has a requirement for the safety distance, the first test content needs to include the safety distance, and the first test indicator needs to include a minimum safety distance. When the first scenario has a requirement for the traffic rule, the first test content needs to include the compliance, and the first test indicator needs to include the traffic rule. When the first scenario has a requirement on comfort, the first test content needs to include the driving stability, and the first test indicator needs to include a quantity of emergency brakes, a quantity of emergency accelerations, or the like.

The first test method that corresponds to the first scenario may be determined based on the test manner that is applicable to the first scenario (that is, the first test manner), the test content that is applicable to the first scenario (that is, the first test content), and the test indicator that is applicable to the first scenario (that is, the first test indicator). For example, the first scenario A indicates a night, a rainy day, a mountainous area, and a national highway. Considering the construction difficulty of the actual scenario, for the first scenario A, the test manner may be the simulation evaluation, the test content may include the compliance, the danger degree, and the driving stability, and the test indicator may be a large safety distance (for example, 10 seconds), a general driving stability, and strictly abiding by traffic rules such as speed limitation and no overtaking. The first scenario B may indicate daytime, a sunny day, a suburb, and an expressway. Considering the construction difficulty of the actual scenario, for the first scenario B, the test manner may be the simulation evaluation, the test content may include the compliance, the danger degree, and the driving stability, and the test indicator may be a common safety distance (for example, 5 seconds), a high driving stability, and strictly abiding by traffic rules such as speed limitation and no following.

In a possible implementation, a correspondence between the test method and the scenario may be preset, a correspondence with one or more of the time information, weather information, terrain information, road information, and motion status information of the traffic participant may be searched, and a test manner, test content, and a test indicator that are indicated by a test method in a found correspondence may be determined as the first test manner, the first test content, and the first test indicator that are indicated by the first scenario.

In this embodiment of this application, the test method for performing a performance test on the intelligent driving system can be determined based on a scenario in which a test needs to be performed, so that adaptation between the test method and the scenario in which the test needs to be performed is improved, and accuracy of the performance test of the intelligent driving system in the scenario is improved.

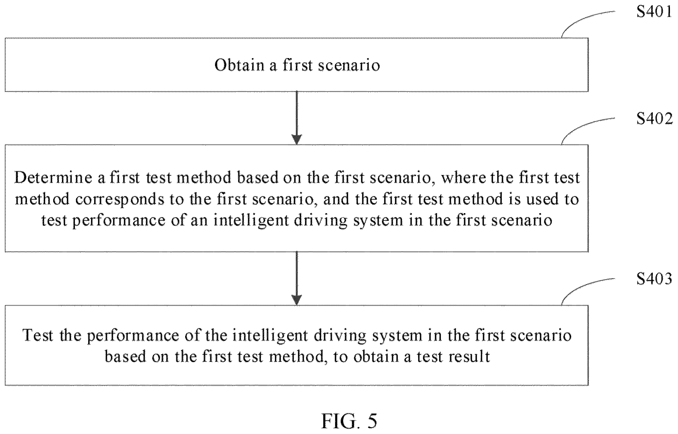

FIG. 5 is a flowchart of the test method according to this embodiment of this application. As shown in FIG. 5, based on FIG. 4, the test method may further include the following steps.

Step S403: Test the performance of the intelligent driving system in the first scenario based on the first test method, to obtain a test result.

The test result is that a test is passed or the test is not passed. If the test is passed, it indicates that the intelligent driving system may normally run in the first scenario, and the first scenario is the safe scenario. If the test is not passed, it indicates that the intelligent driving system may not normally run in the first scenario, and the first scenario is the unsafe scenario.

In a possible implementation, step S403 may include: simulating the first scenario based on the first test manner; in a simulated first scenario, running the intelligent driving system based on the first test content, to obtain running data of the intelligent driving system in the first scenario; and determining, based on whether the running data meets the first test indicator, whether the test result is that the test is passed or the test is not passed.

The running data includes but is not limited to a location, a speed, an acceleration, a driving direction, and the like. It may be understood that the running data is obtained based on the first test content, and the running data uses the first test indicator as a judgment criterion. When the running data meets the first test indicator, it may be determined that the test result is that the test is passed. When the running data does not meet the first test indicator, it may be determined that the test result is that the test is not passed.

In this embodiment of this application, the performance of the intelligent driving system in the first scenario is tested by the first test method that is applicable to the first scenario, the accuracy of the performance test of the intelligent driving system in the scenario is improved.

In a possible implementation, the method further includes: when the test result is that the test is passed, adding the first scenario to a scenario library supported by the intelligent driving system, and recording a sensing capability and a driving strategy of the intelligent driving system running in the first scenario.

The sensing capability refers to a sensing capability of the intelligent driving system on a surrounding environment of the vehicle (for example, a pedestrian, a vehicle, a lane, a traffic light, an obstacle, a green belt, or a street building). The sensing capability is related to a sensor of the vehicle. It may be understood that, when a speed of the vehicle is fast, a strong sensing capability is required; and in a congested road section, the strong sensing capability is required. When the sensing capability is inadequate, the intelligent driving system may allocate some computing resources to sensing, to improve the sensing capability. The driving strategy refers to a driving planning algorithm of the intelligent driving system. For example, the driving strategy for a rainy day or a foggy day may include a large safety distance, reduction of a vehicle speed, and the like. The driving strategy for a foggy day may further include turning on a fog light, honking, and the like.

When the test result is that the test is passed, it indicates that the intelligent driving system may normally run in the first scenario, and the first scenario is the safe scenario. Therefore, the first scenario may be added to the scenario library supported by the intelligent driving system, and the sensing capability and the driving strategy of the intelligent driving system may be recorded when the intelligent driving system runs in the first scenario. In this way, when the intelligent driving system encounters the first scenario again, the intelligent driving system may determine, based on the supported scenario library, that the first scenario is the safe scenario, and may use a sensing capability and a driving strategy that correspond to the first scenario, to implement safe driving.

In an example, the intelligent driving system may determine, based on one or more of current time information, weather information, terrain information, road information, and motion status information of a traffic participant, whether the current scenario is a scenario supported by the intelligent driving system, that is, the safe scenario. When one or more of the current time information, weather information, terrain information, road information, and motion status information of the traffic participant match one or more of the time information, weather information, terrain information, road information, and motion status information of the traffic participant that are indicated by the first scenario in the scenario library supported by the intelligent driving system, the first scenario may be determined as a scenario in which the intelligent driving system is currently located, and in addition, running is performed based on the sensing capability and the driving strategy of the intelligent driving system running in the first scenario, to implement safe driving.

In this embodiment of this application, by storing the first scenario that passes the test, and the sensing capability and the driving strategy that correspond to the first scenario, safe driving can be implemented when the vehicle encounters the first scenario again.

In a possible implementation, the method further includes: when the test result is that the test is not passed, analyzing a reason why the test of the intelligent driving system in the first scenario is not passed; and updating the intelligent driving system based on the reason, to enable the test result of the intelligent driving system in the first scenario to be changed to that the test is passed.

If the test is not passed, it indicates that the intelligent driving system may not normally run in the first scenario, and the first scenario is the unsafe scenario. To enable the intelligent driving system to implement safe driving in the first scenario, in this embodiment of this application, the reason why the test of the intelligent driving system in the first scenario is not passed may be analyzed, and the intelligent driving system is updated, so that the test result of the intelligent driving system in the first scenario is changed to that the test is passed, in other words, the first scenario is changed from the unsafe scenario to the safe scenario. It may be understood that, after the test result of the intelligent driving system in the first scenario is changed to that the test is passed, the first scenario may be added to the scenario library supported by the intelligent driving system, and a sensing capability and a driving strategy of an updated intelligent driving system are recorded when the intelligent driving system runs in the first scenario. In this way, safe driving can be implemented when the vehicle encounters the first scenario again.

In a possible implementation, the updating the intelligent driving system based on the reason may include: when the reason is a sensor sensing error, improving the sensing capability of the intelligent driving system in the first scenario.

In a possible implementation, the updating the intelligent driving system based on the reason may include: when the reason is a driving strategy parameter error, adjusting the driving strategy of the intelligent driving system in the first scenario.

The parameter of the driving strategy includes but is not limited to a speed, a safety distance, an acceleration, and the like.

In a possible implementation, the updating the intelligent driving system based on the reason may include: when the reason is the sensor sensing error and the driving strategy parameter error, improving the sensing capability of the intelligent driving system in the first scenario, and adjusting the driving strategy of the intelligent driving system in the first scenario.

It should be noted that the foregoing is only an example of the reason why the test of the intelligent driving system in the first scenario is not passed. There may be another reason why the test is not passed. In addition, the foregoing is only an example of a manner of updating the intelligent driving system. Based on the another reason, there may be another manner of updating the intelligent driving system. This is not limited in this embodiment of this application.

In a possible implementation, the method further includes: when the test result is that the test is passed, sending, to a cloud and/or another vehicle, the first scenario, and the sensing capability and the driving strategy of the intelligent driving system running in the first scenario, to enable the cloud and/or the another vehicle to update the scenario library supported by the intelligent driving system, and recording the sensing capability and the driving strategy of the intelligent driving system running in the first scenario.

In this embodiment of this application, by sending, to the cloud and/or the another vehicle, the first scenario that passes the test, and the sensing capability and the driving strategy that correspond to the first scenario, safe driving of an intelligent driving system of the another can be implemented in the first scenario.

In a possible implementation, the method further includes: when the test result is that the test is passed, sending the first scenario and the first test method to the cloud and/or the another vehicle, to enable the cloud and/or the another vehicle to test the performance of the intelligent driving system in the first scenario based on the first test method.

In this embodiment of this application, by sending, to the cloud and/or the another vehicle, the first test method that corresponds to the first scenario that passes the test, performance of the intelligent driving system of the cloud and/or the another vehicle in the first scenario is accurately tested, to facilitate safe driving of the another vehicle in the first scenario.

In a possible implementation, the first scenario that passes the test, the sensing capability and the driving strategy that correspond to the first scenario, and the first test method may be sent by using an over-the-air technology (Over-the-Air Technology, OTA).

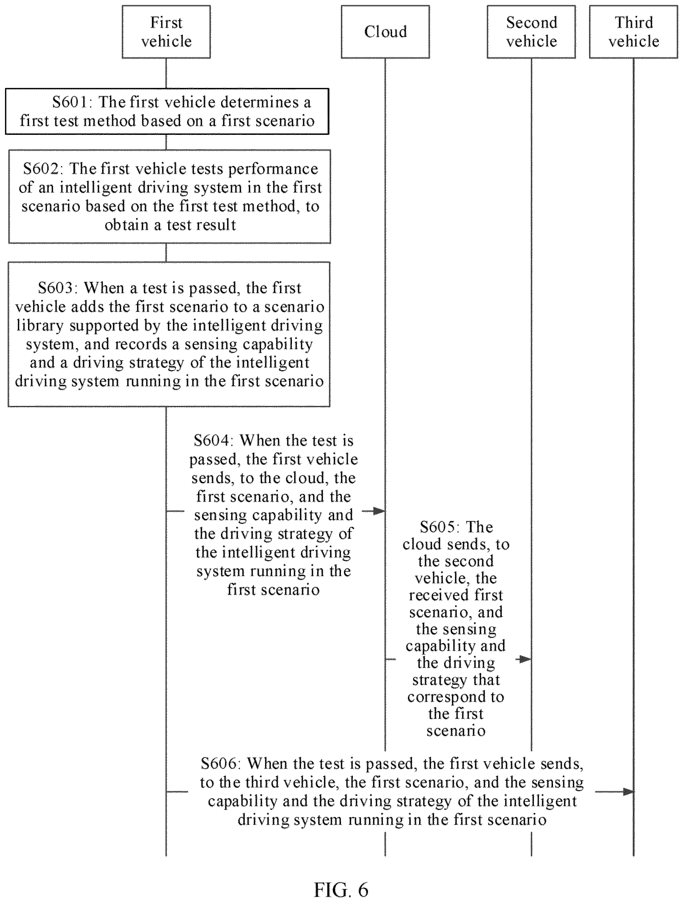

FIG. 6 is an interaction flowchart of a test method according to an embodiment of this application. As shown in FIG. 6, the method includes the following steps.

Step S601: A first vehicle determines a first test method based on a first scenario.

Step S602: The first vehicle tests performance of an intelligent driving system in the first scenario based on the first test method, to obtain a test result.

Step S603: When a test is passed, the first vehicle adds the first scenario to a scenario library supported by the intelligent driving system, and records a sensing capability and a driving strategy of the intelligent driving system running in the first scenario.

Step S604: When the test is passed, the first vehicle sends, to a cloud, the first scenario, and the sensing capability and the driving strategy of the intelligent driving system running in the first scenario.

Step S605: The cloud sends, to a second vehicle, the received first scenario, and the sensing capability and the driving strategy that correspond to the first scenario.

In this way, the second vehicle can implement safe driving when encountering the first scenario.

Step S606: When the test is passed, the first vehicle sends, to a third vehicle, the first scenario, and the sensing capability and the driving strategy of the intelligent driving system running in the first scenario.

In this way, the third vehicle can implement safe driving when encountering the first scenario.

It should be noted that the first vehicle may be any vehicle, the second vehicle and the third vehicle each may represent a vehicle that has a same intelligent driving system as the first vehicle, and step S604 and step S606 are optional. In an example, the first vehicle in steps S601 to S606 may be changed to the cloud. In this case, steps S604 and S605 do not need to be performed. In another example, the first vehicle in steps S601 to S606 may be alternatively changed to another electronic device that has a first scenario test capability. This is not limited in this embodiment of this application.

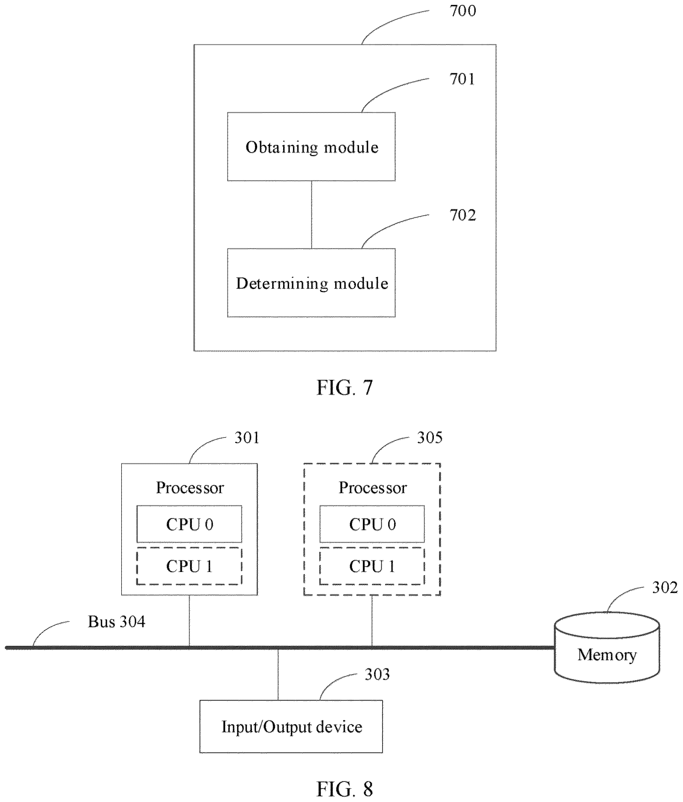

FIG. 7 is a schematic diagram of a structure of a test apparatus according to an embodiment of this application. As shown in FIG. 7, the apparatus 700 may include:
an obtaining module 701, configured to obtain a first scenario; and
a determining module 702, configured to determine a first test method based on the first scenario, where the first test method corresponds to the first scenario, and the first test method is used to test performance of an intelligent driving system in the first scenario.

In this embodiment of this application, a test method for performing a performance test on the intelligent driving system can be determined based on a scenario in which a test needs to be performed, so that adaptation between the test method and the scenario in which the test needs to be performed is improved, and accuracy of the performance test of the intelligent driving system in the scenario is improved.

In a possible implementation, the apparatus further includes:
a test module, configured to test the performance of the intelligent driving system in the first scenario based on the first test method, to obtain a test result.

In a possible implementation, the first test method indicates a first test manner, first test content, and a first test indicator, and the test module is further configured to:
simulate the first scenario based on the first test manner;
in a simulated first scenario, run the intelligent driving system based on the first test content, to obtain running data of the intelligent driving system in the first scenario; and
determine, based on whether the running data meets the first test indicator, whether the test result is that a test is passed or the test is not passed.

In a possible implementation, the apparatus further includes:
a recording module, configured to: when the test result is that the test is passed, add the first scenario to a scenario library supported by the intelligent driving system, and record a sensing capability and a driving strategy of the intelligent driving system running in the first scenario.

In a possible implementation, the apparatus further includes:
an analysis module, configured to: when the test result is that the test is not passed, analyze a reason why the test of the intelligent driving system in the first scenario is not passed; and
an updating module, configured to update the intelligent driving system based on the reason, to enable the test result of the intelligent driving system in the first scenario to be changed to that the test is passed.

In a possible implementation, based on the reason, the updating module is further configured to:
when the reason is a sensor sensing error, improve the sensing capability of the intelligent driving system in the first scenario; and/or
when the reason is a driving strategy parameter error, adjust the driving strategy of the intelligent driving system in the first scenario.

In a possible implementation, the apparatus further includes:
a first sending module, configured to: when the test result is that the test is passed, send, to a cloud and/or another vehicle, the first scenario, and the sensing capability and the driving strategy of the intelligent driving system running in the first scenario, to enable the cloud and/or the another vehicle to update the scenario library supported by the intelligent driving system, and record the sensing capability and the driving strategy of the intelligent driving system running in the first scenario.

In a possible implementation, the apparatus further includes:
a second sending module, configured to: when the test result is that the test is passed, send the first scenario and the first test method to the cloud and/or the another vehicle, to enable the cloud and/or the another vehicle to test the performance of the intelligent driving system in the first scenario based on the first test method.

In a possible implementation,
the first test manner includes at least one or more of simulation evaluation, a closed field test, and an actual road test.

The first test content includes at least one or more of compliance, a danger degree, and driving stability.

The first test indicator includes at least one or more of a safety distance and/or a traffic rule.

In a possible implementation, the first scenario indicates one or more of time information, weather information, terrain information, road information, and motion status information of a traffic participant.

The obtaining module is further configured to:
when an error occurs during running of the intelligent driving system of an ego vehicle or a danger is prompted, obtain one or more of current time information, weather information, terrain information, road information, and motion status information of a traffic participant, to obtain the first scenario.

In a possible implementation, the determining module is configured to:
determine, based on construction difficulty of an actual scenario of the first scenario, a test manner that is applicable to the first scenario;
determine, based on a safety need of the first scenario, test content and a test indicator that are applicable to the first scenario; and
determine, based on the test manner, the test content, and the test indicator that are applicable to the first scenario, the first test method that corresponds to the first scenario.

FIG. 8 is a schematic diagram of a structure of a test apparatus according to an embodiment of this application. The test apparatus may be deployed in a terminal device like a vehicle, or may be deployed in a cloud server.

As shown in FIG. 8, the test apparatus may include at least one processor 301, a memory 302, an input/output device 303, and a bus 304. Components of the test apparatus are specifically described in the following with reference to FIG. 8.

The processor 301 is a control center of the test apparatus, and may be one processor, or may be a collective name of a plurality of processing elements. For example, the processor 301 may be a central processing unit (Central Processing Unit, CPU), or an application-specific integrated circuit (Application-Specific Integrated Circuit, ASIC), or may be configured as one or more integrated circuits implementing embodiments of the present disclosure, for example, one or more microprocessors (Digital Signal Processors, DSPs) or one or more field programmable gate arrays (Field Programmable Gate Arrays, FPGAs).

The processor 301 may execute various functions of the test apparatus by running or executing a software program stored in the memory 302 and invoking data stored in the memory 302.

In a specific implementation, in an embodiment, the processor 301 may include one or more CPUs, for example, a CPU 0 and a CPU 1 shown in the figure.

In a specific implementation, in an embodiment, the test apparatus may include a plurality of processors, for example, the processor 301 and a processor 305 shown in FIG. 8. Each of the processors may be a single core processor (single-CPU), or may be a multi-core processor (multi-CPU). The processor herein may be one or more devices, circuits, and/or processing cores configured to process data (for example, computer program instructions).

The memory 302 may be a read-only memory (Read-Only Memory, ROM) or another type of static storage device that can store static information and instructions, a random access memory (Random Access Memory, RAM) or another type of dynamic storage device that can store information and instructions, an electrically erasable programmable read-only memory (Electrically Erasable Programmable Read-Only Memory, EEPROM), a compact disc read-only memory (Compact Disc Read-Only Memory, CD-ROM) or another compact disc storage, an optical disc storage (including a compact disc, a laser disc, an optical disc, a digital versatile disc, a Blu-ray disc, and the like), a disk storage medium or another magnetic storage device, or any other medium that can be configured to carry or store expected program code in a form of instructions or a data structure and that can be accessed by a computer. This is not limited thereto. The memory 302 may exist independently, and may be connected to the processor 301 through the bus 304. The memory 302 may alternatively be integrated with the processor 301.

The input/output device 303 is configured to communicate with another device or a communication network, for example, is configured to communicate with a communication network like an Ethernet, a radio access network (radio access network, RAN), or a wireless local area network (Wireless Local Area Networks, WLAN). The input/output device 303 may include all or part of a baseband processor, and may further optionally include a radio frequency (Radio Frequency, RF) processor. The RF processor is configured to send or receive an RF signal. The baseband processor is configured to process a baseband signal converted from an RF signal or a baseband signal to be converted into an RF signal.

In a specific implementation, in an embodiment, the input/output device 303 may include a transmitter and a receiver. The transmitter is configured to send a signal to another device or a communication network, and the receiver is configured to receive a signal sent by the another device or the communication network. The transmitter and the receiver may exist independently, or may be integrated together.

The bus 304 may be an industry standard architecture (Industry Standard Architecture, ISA) bus, a peripheral component interconnect (Peripheral Component Interconnect, PCI) bus, an extended industry standard architecture (Extended Industry Standard Architecture, EISA) bus, or the like. The bus may be classified into an address bus, a data bus, a control bus, and the like. For ease of representation, only one thick line is used to represent the bus in FIG. 8, but this does not mean that there is only one bus or only one type of bus.

The structure of the device shown in FIG. 8 does not constitute a limitation on the test apparatus. The test apparatus may include more or fewer components than those shown in the figure, or combine some components, or have different component arrangements.

An embodiment of this application provides a test apparatus. The test apparatus includes a processor and a memory that is configured to store executable instructions of the processor. The processor is configured to implement the foregoing method when executing the instructions.

An embodiment of this application provides a non-volatile computer-readable storage medium, storing computer program instructions. When the computer program instructions are executed by a processor, the foregoing method is implemented.

An embodiment of this application provides a computer program product, including computer-readable code or a non-volatile computer-readable storage medium carrying the computer-readable code. When the computer-readable code runs in a processor of an electronic device, the processor in the electronic device performs the foregoing method.

The computer-readable storage medium may be a tangible device that can retain and store instructions for use by an instruction execution device. The computer-readable storage medium may be, for example, (but is not limited to), an electric storage device, a magnetic storage device, an optical storage device, an electromagnetic storage device, a semiconductor storage device, or any suitable combination of the foregoing. More specific examples (non-exhaustive list) of the computer-readable storage medium include: a portable computer disk, a hard disk, a random access memory (Random Access Memory, RAM), a read-only memory (Read-Only Memory, ROM), an erasable programmable read-only memory (Erasable Programmable Read-Only Memory, EPROM, or flash memory), a static random-access memory (Static Random-Access Memory, SRAM), a portable compact disc read-only memory (Compact Disc Read-Only Memory, CD-ROM), a digital versatile disc (Digital Versatile Disc, DVD), a memory stick, a floppy disk, a mechanical coding device, for example, a punching card or a groove protrusion structure that stores instructions and that is on the mechanical coding device, and any suitable combination thereof.

The computer-readable program instructions or code described herein may be downloaded from the computer-readable storage medium to computing/processing devices or to an external computer or external storage device through a network like the internet, a local area network, a wide area network, and/or a wireless network. The network may include a copper transmission cable, optical fiber transmission, wireless transmission, a router, a firewall, a switch, a gateway computer and/or an edge server. A network adapter card or network interface in each computing/processing device receives the computer-readable program instructions from the network and forwards the computer-readable program instructions for storage in a computer-readable storage medium in each computing/processing device.

The computer program instructions used to perform operations in this application may be an assembly instruction, an instruction set architecture (Instruction Set Architecture, ISA) instruction, a machine instruction, a machine-related instruction, microcode, a firmware instruction, status setting data, or source code or target code written in any combination of one or more programming languages. The programming languages include an object-oriented programming language like Smalltalk and C++, and a conventional procedural programming language like a "C" language or a similar programming language. The computer-readable program instructions may be entirely executed on a user computer, partly on the user computer, as a stand-alone software package, partly on the user computer and partly on a remote computer, or entirely on the remote computer or a server. When a remote computer is involved, the remote computer may be connected to a user computer through any type of network, including a local area network (Local Area Network, LAN) or a wide area network (Wide Area Network, WAN), or may be connected to an external computer (for example, connected by using an internet service provider through the internet). In some embodiments, an electronic circuit, for example, a programmable logic circuit, a field-programmable gate array (Field-Programmable Gate Array, FPGA), or a programmable logic array (Programmable Logic Array, PLA) is customized by based on status information of the computer-readable program instructions. The electronic circuit may execute the computer-readable program instructions, to implement the various aspects of this application.

The various aspects of this application are described herein with reference to the flowcharts and/or block diagrams of the method, the apparatus (system), and the computer program product according to embodiments of this application. It should be understood that each block of the flowcharts and/or block diagrams and a combination of blocks in the flowcharts and/or block diagrams may be implemented by the computer-readable program instructions.

These computer-readable program instructions may be provided to a processor of a general-purpose computer, a special-purpose computer, or another programmable data processing apparatus to produce a machine, so that the instructions, when executed by the processor of the computer or the another programmable data processing apparatus, create an apparatus for implementing functions/acts specified in one or more blocks in the flowcharts and/or block diagrams. These computer-readable program instructions may alternatively be stored in the computer-readable storage medium. These instructions enable a computer, a programmable data processing apparatus, and/or another device to work in a specific manner. Therefore, the computer-readable medium storing the instructions includes an artifact that includes instructions for implementing the various aspects of the functions/acts specified in the one or more blocks in the flowcharts and/or the block diagrams.

The computer-readable program instructions may alternatively be loaded onto a computer, another programmable data processing apparatus, or another device, so that a series of operation steps is performed on the computer, the another programmable data processing apparatus, or the another device to produce a computer-implemented process. Therefore, the instructions executed on the computer, the another programmable data processing apparatus, or the another device implements the functions/acts specified in the one or more blocks in the flowcharts and/or block diagrams.

The flowcharts and block diagrams in the accompanying drawings show system architectures, functions, and operations that may be implemented by the apparatus, system, method, and computer program product according to a plurality of embodiments of this application. In this regard, each block in the flowcharts or block diagrams may represent a module, a program segment, or a part of the instructions, and the module, the program segment, or the part of the instructions includes one or more executable instructions for implementing a specified logical function. In some alternative implementations, a function marked in the block may also occur in a sequence different from that marked in the accompanying drawings. For example, two consecutive blocks may actually be executed substantially in parallel, and may sometimes be executed in a reverse order, depending on a function involved.

It should also be noted that each block in the block diagram and/or the flowchart, and a combination of blocks in the block diagram and/or the flowchart may be implemented by hardware (for example, a circuit or an application-specific integrated circuit (Application-Specific Integrated Circuit, ASIC)) that performs a corresponding function or an action, or may be implemented by a combination of hardware and software, for example, firmware.
The foregoing has described embodiments of this application. The foregoing descriptions are examples, are not exhaustive, and are not limited to the disclosed embodiments. A plurality of modifications and variations are apparent to a person of ordinary skill in the art without departing from the scope of the described embodiments. Selection of terms used in this specification is intended to best explain principles of embodiments, actual application, or improvements to technologies in the market, or to enable another person of ordinary skill in the art to understand embodiments disclosed in this specification.

## Claims

1. A test method, wherein the method comprises:
obtaining a first scenario; and
determining a first test method based on the first scenario, wherein the first test method corresponds to the first scenario, and the first test method is used to test performance of an intelligent driving system in the first scenario.

2. The method according to claim 1, wherein the method further comprises:
testing the performance of the intelligent driving system in the first scenario based on the first test method, to obtain a test result.

3. The method according to claim 2, wherein the first test method indicates a first test manner, first test content, and a first test indicator, and the testing the performance of the intelligent driving system in the first scenario based on the first test method, to obtain a test result comprises:
simulating the first scenario based on the first test manner;
in a simulated first scenario, running the intelligent driving system based on the first test content, to obtain running data of the intelligent driving system in the first scenario; and
determining, based on whether the running data meets the first test indicator, whether the test result is that a test is passed or the test is not passed.

4. The method according to claim 2 or 3, wherein the method further comprises:
when the test result is that the test is passed, adding the first scenario to a scenario library supported by the intelligent driving system, and recording a sensing capability and a driving strategy of the intelligent driving system running in the first scenario.

5. The method according to any one of claims 2 to 4, wherein the method further comprises:
when the test result is that the test is not passed, analyzing a reason why the test of the intelligent driving system in the first scenario is not passed; and
updating the intelligent driving system based on the reason, to enable the test result of the intelligent driving system in the first scenario to be changed to that the test is passed.

6. The method according to claim 5, wherein the updating the intelligent driving system based on the reason comprises:
when the reason is a sensor sensing error, improving the sensing capability of the intelligent driving system in the first scenario; and/or
when the reason is a driving strategy parameter error, adjusting the driving strategy of the intelligent driving system in the first scenario.

7. The method according to any one of claims 3 to 6, wherein the method further comprises:
when the test result is that the test is passed, sending, to a cloud and/or another vehicle, the first scenario, and the sensing capability and the driving strategy of the intelligent driving system running in the first scenario, to enable the cloud and/or the another vehicle to update the scenario library supported by the intelligent driving system, and record the sensing capability and the driving strategy of the intelligent driving system running in the first scenario.

8. The method according to any one of claims 3 to 7, wherein the method further comprises:
when the test result is that the test is passed, sending the first scenario and the first test method to the cloud and/or the another vehicle, to enable the cloud and/or the another vehicle to test the performance of the intelligent driving system in the first scenario based on the first test method.

9. The method according to any one of claims 3 to 8, wherein
the first test manner comprises at least one or more of simulation evaluation, a closed field test, and an actual road test;
the first test content comprises at least one or more of compliance, a danger degree, and driving stability; and
the first test indicator comprises at least one or more of a safety distance and/or a traffic rule.

10. The method according to any one of claims 1 to 9, wherein the first scenario indicates one or more of time information, weather information, terrain information, road information, and motion status information of a traffic participant; and
the obtaining a first scenario comprises:
when an error occurs during running of the intelligent driving system of an ego vehicle or a danger is prompted, obtaining one or more of current time information, weather information, terrain information, road information, and motion status information of a traffic participant, to obtain the first scenario.

11. The method according to claim 10, wherein the determining a first test method based on the first scenario comprises:
determining, based on construction difficulty of an actual scenario of the first scenario, a test manner that is applicable to the first scenario;
determining, based on a safety need of the first scenario, test content and a test indicator that are applicable to the first scenario; and
determining, based on the test manner, the test content, and the test indicator that are applicable to the first scenario, the first test method that corresponds to the first scenario.

12. A test apparatus, wherein the apparatus comprises:
an obtaining module, configured to obtain a first scenario; and
a determining module, configured to determine a first test method based on the first scenario, wherein the first test method corresponds to the first scenario, and the first test method is used to test performance of an intelligent driving system in the first scenario.

13. The apparatus according to claim 12, wherein the apparatus further comprises:
a test module, configured to test the performance of the intelligent driving system in the first scenario based on the first test method, to obtain a test result.

14. The apparatus according to claim 13, wherein the first test method indicates a first test manner, first test content, and a first test indicator, and the test module is further configured to:
simulate the first scenario based on the first test manner;
in a simulated first scenario, run the intelligent driving system based on the first test content, to obtain running data of the intelligent driving system in the first scenario; and
determine, based on whether the running data meets the first test indicator, whether the test result is that a test is passed or the test is not passed.

15. The apparatus according to claim 13 or 14, wherein the apparatus further comprises:
a recording module, configured to: when the test result is that the test is passed, add the first scenario to a scenario library supported by the intelligent driving system, and record a sensing capability and a driving strategy of the intelligent driving system running in the first scenario.

16. The apparatus according to any one of claims 13 to 15, wherein the apparatus further comprises:
an analysis module, configured to: when the test result is that the test is not passed, analyze a reason why the test of the intelligent driving system in the first scenario is not passed; and
an updating module, configured to update the intelligent driving system based on the reason, to enable the test result of the intelligent driving system in the first scenario to be changed to that the test is passed.

17. The apparatus according to claim 16, wherein based on the reason, the updating module is further configured to:
when the reason is a sensor sensing error, improve the sensing capability of the intelligent driving system in the first scenario; and/or
when the reason is a driving strategy parameter error, adjust the driving strategy of the intelligent driving system in the first scenario.

18. The apparatus according to any one of claims 14 to 17, wherein the apparatus further comprises:
a first sending module, configured to: when the test result is that the test is passed, send, to a cloud and/or another vehicle, the first scenario, and the sensing capability and the driving strategy of the intelligent driving system running in the first scenario, to enable the cloud and/or the another vehicle to update the scenario library supported by the intelligent driving system, and record the sensing capability and the driving strategy of the intelligent driving system running in the first scenario.

19. The apparatus according to any one of claims 14 to 18, wherein the apparatus further comprises:
a second sending module, configured to: when the test result is that the test is passed, send the first scenario and the first test method to the cloud and/or the another vehicle, to enable the cloud and/or the another vehicle to test the performance of the intelligent driving system in the first scenario based on the first test method.

20. The apparatus according to any one of claims 14 to 19, wherein
the first test manner comprises at least one or more of simulation evaluation, a closed field test, and an actual road test;
the first test content comprises at least one or more of compliance, a danger degree, and driving stability; and
the first test indicator comprises at least one or more of a safety distance and/or a traffic rule.

21. The apparatus according to any one of claims 14 to 20, wherein the first scenario indicates one or more of time information, weather information, terrain information, road information, and motion status information of a traffic participant; and
the obtaining module is further configured to:
when an error occurs during running of the intelligent driving system of an ego vehicle or a danger is prompted, obtain one or more of current time information, weather information, terrain information, road information, and motion status information of a traffic participant, to obtain the first scenario.

22. The apparatus according to claim 21, wherein the determining module is further configured to:
determine, based on construction difficulty of an actual scenario of the first scenario, a test manner that is applicable to the first scenario;
determine, based on a safety need of the first scenario, test content and a test indicator that are applicable to the first scenario; and
determine, based on the test manner, the test content, and the test indicator that are applicable to the first scenario, the first test method that corresponds to the first scenario.

23. A test apparatus, comprising:
a processor; and
a memory, configured to store executable instructions of the processor, wherein
when the processor is configured to execute the instructions, the method according to any one of claims 1 to 11 is implemented.

24. A non-volatile computer-readable storage medium, storing computer program instructions, wherein when the computer program instructions are executed by a processor, the method according to any one of claims 1 to 11 is implemented.

25. A computer program product, comprising computer-readable code or a non-volatile computer-readable storage medium carrying computer-readable code, wherein when the computer-readable code runs in an electronic device, a processor in the electronic device performs the method according to any one of claims 1 to 11.
